# EUROPEAN PATENT SPECIFICATION

(11) **EP 1 428 259 B1**
(45) Date of publication and mention of the grant of the patent: **09.07.2014**
(21) Application number: 02794581.5
(22) Date of filing: 07.08.2002
(51) Int. Cl.: H01L 23/50, H01L 25/07, H01L 23/60

(54) **SEMICONDUCTOR MODULE**
HALBLEITERMODUL
MODULE DE SEMI-CONDUCTEUR

(30) Priority: 09.08.2001 DE 10139287
(43) Date of publication of application: 16.06.2004
(73) Proprietor: Bombardier Transportation GmbH, 10785 Berlin (DE)
(72) Inventor: KRAMER, Wilhelm, 69207 Sandhausen (DE); HARTUNG, German, 68199 Mannheim (DE)
(74) Representative: Broydé, Marc
(86) International application number: PCT/EP2002/008845
(87) International publication number: WO 2003/015167

(56) References cited:
- EP-A- 0 547 877
- EP-A- 0 825 649
- EP-A- 0 828 341
- EP-A- 1 041 626
- EP-A- 1 063 700
- EP-A- 1 160 861
- HERRMANN J ET AL: "FARADAY SHIELD IMPLEMENTATION IN A POWER STACK FOR A HYBRID CIRCUIT" MOTOROLA TECHNICAL DEVELOPMENTS, MOTOROLA INC. SCHAUMBURG, ILLINOIS, US, vol. 10, 1 March 1990 (1990-03-01), page 99 XP000114671 ISSN: 0887-5286

## Description

The invention relates to a semiconductor module whose semiconductor chips are arranged on a base/intermediate plate. The semiconductor module proposed can be used for example in the configuration of power converter apparatuses, in particular for electrical rail traffic, such as auxiliary operation converters, on-board power supply converters, step-up converters and power converter cascades.

EP 0 547 877 A2 describes a semiconductor module.

In order to enable the operation of semiconductor modules mounted on a cooler with increased voltage, it is generally known to provide so-called "insulation islands" or "cooling islands" on the cooler. In these constructions, aluminium or copper discs are applied to the cooler at a predetermined distance and encapsulated by casting with an insulating collar (insulating casting) in order to form a sufficient creepage path length. This solution is highly cost-intensive with regard to production. A further disadvantage here is the only limited heat dissipation capability. In addition, problems arise with regard to the required precision casting and the long-term strength (security against partial discharges PD). Very small shrink holes in the insulating casting can lead to breakdown during later operation.

The invention is based on the object of providing a semiconductor module of the type mentioned in the introduction which enables operation of the semiconductor module with high voltage in a comparatively simple and cost-effective manner.

This object is achieved by means of a semiconductor module according to claim 1.

The invention makes it possible to use, in particular, low-voltage IGBT modules (i.e. IGBT modules designed for low voltage) at higher voltage levels. Thus, by way of example, a module conventionally designed for 650 V can be used for 1300 V, 2600 V or 3900 V. This universal usability at low and the aforementioned high voltages is brought about by the functional interaction of insulating frame and potential connections between base/intermediate plate and emitter or gate potential (electrical connections). Particularly in the edge regions and the chips base/intermediate plate, critical voltage loads or the electrical field strength between the transistors/diode chips and the metallic, that is to say electrically conductive, base/ intermediate plate are reduced to a few volts. The loading zones that are critical for the electrical field strength are moved to the highly insulating ceramic plate, the insulating frame (whose structural height preferably corresponds at least to that of the semiconductor module). The magnitude of the field strengths that occur is greatly reduced.

A preferred exemplary embodiment of the invention is distinguished by the fact that the contour of the insulating frame encloses the semiconductor module and the said insulating frame, projects via fixing holes in the base/intermediate plate, pressure fittings that press against the base/intermediate plate being integrated in the insulating frame and the insulating frame having cutouts for screwing on the cooler.

The advantages that can be obtained by means of the invention consist in particular in the fact that the proposed insulating frame with intermediately clamped or integrated ceramic plate enables very good heat dissipation, since a ceramic material with very good heat dissipation capacity can be used and the semiconductor module can be pressed against the cooler with standard contact pressure. Additional processing of the surface of the cooler is not necessary, rather it is possible to use standard coolers (advantageously air or liquid coolers). Cost advantages result compared with HPP modules since, particularly in auxiliary converter applications, the application of the semiconductor modules on the cooler is greatly simplified and becomes variable. At the same time, high security against partial discharges, an increased dielectric strength and long-term stability are obtained. Accordingly, the use of the insulating frame considerably increases the possible voltage loading and the electrical creepage paths/flashover distances present in comparison with mounting without an insulating frame and in comparison with generally known solution approaches.

The invention makes it possible, for an arbitrary variety of power converter circuits (variants), to use, without difficulty, standard semiconductor modules with high power benefit, increased electrical operational reliability and reduced probability of failure. In this case, series circuits, parallel circuits and also series/parallel circuits (voltage doubling, voltage quadrupling, cascade power converters) of the semiconductor modules are possible. The compact, space-saving arrangement of semiconductor modules on the cooler is always ensured. Undefined voltage potentials between semiconductor chips and semiconductor base/intermediate plate or between semiconductor modules or semiconductor assemblies or chip groups or IGBT individual switches and coolers are prevented. The electrical field strengths between semiconductor chips and base/intermediate plate are reduced to insignificant values.

Further details, features and advantages of the invention emerge from the following description of a preferred exemplary embodiment and the diagrammatic drawing and the subclaims. In the figures:
- Fig. 1: shows a semiconductor module according to the invention in partial section on line I-I of Fig. 2,
- Fig. 2: shows a plan view of the semiconductor module according to the invention as shown in Fig. 1,
- Fig. 3: shows a detail illustration of an IGBT semiconductor module with an insulating frame according to the invention in section on line I-II of Fig. 2,
- Fig. 4: shows the chip/DCB field line profile in the case of a semiconductor module according to the invention,
- Fig. 5: shows the chip/DCB field line profile in the case of conventional semiconductor modules,
- Fig. 6: shows a first section through a further embodiment of the semiconductor module according to the invention with an additional screen,
- Fig. 7: shows a second section through the embodiment of the semiconductor module of Fig. 6,
- Fig. 8: shows the screen of the semiconductor module of Figs. 6, 7 in perspective view, and
- Figs. 9, 10: show possibilities for the defined potential division between chips and base/intermediate plate.

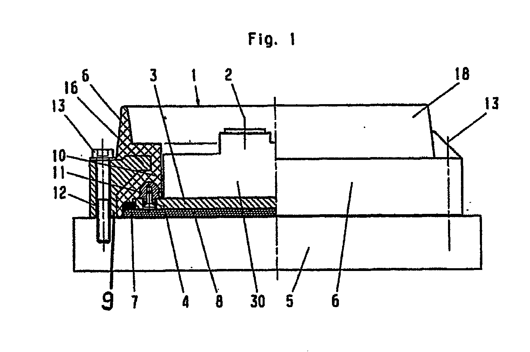

Fig. 1 shows a basic illustration of a semiconductor module 1 in partial section. The associated semiconductor assembly 30 has electrical connections 2 at its top side and an electrically conductive base/inter-mediate plate 3 at its underside. Fixing holes 4 in the edge region of the base/intermediate plate 3 serve for the mounting and centring of the semiconductor module 1 in an insulating frame 6, for example by means of pressure fittings 11 or other connecting elements.

The semiconductor module 1 is mounted on a liquid- or air-cooled cooler 5, but not by means of the generally known direct screwing, but rather via the fixing holes 4, the holes 12 and also the fixing screws 13 of a rectangular, appropriate square insulating frame 6.

This insulating frame 6 presses the semiconductor assembly 30 or assemblies against the cooler 5 via an interposed ceramic plate 8. In this case, the ceramic plate 8, preferably composed of aluminium nitride or aluminium oxide, has a slightly larger area than the base/intermediate plate 3, with the result than a peripheral free edge area having a predetermined constant width is produced on the ceramic plate 8, which is suitable for receiving or for interposing a peripheral, elastic electrical seal 7 in the space between insulating frame 6, ceramic plate 8 and base/intermediate plate 3. A soft rubber or plastic ring without conductive dopings preferably serves as the electrical seal 7. A coating with silicone paste or substitutes yields an oxygen exclusion for the rubber or plastic material, which ensures an expected service life of thirty years or more without difficulty. The electrical seals 7, together with the ceramic plate 8 and the insulating frame 6 including cast-on or injection-moulded insulating body 10 functions as electrical barrier and prevents a charge carrier transport. In the case of particularly high voltage requirements, it is also possible to arrange two sealing rings "one in the other" (virtually electrically connected in series) in one plane.

It is important to make the ceramic plate 8 thick enough, in order that the electrical field strength that occurs remains sufficiently low, thereby yielding (in connection with further measures) a high security with regard to the "partial discharge" criterion. Even in the case of an unlikely fracture of the ceramic plate 8, flashovers or breakdowns do not occur since the charge carriers required therefor cannot be produced owing to the low yield strength that occurs.

In accordance with one embodiment, the insulating frame 6 is constructed from two main components, an inner frame 9 - which preferably comprises metal (aluminium casting) - and an insulating body 10, which encloses and/or encapsulates the said frame 9 and is preferably formed from an electrically insulating plastic, in particular a carbon-fibre-reinforced plastic - such as epoxy resin, polyester resin, PPS material without conducting means doping. The configuration of the stable frame 9 within the insulating body 10 ensures that the insulating material is not exposed to tension or sheer, but predominantly to pressure. It is important that a material which is resistant with regard to partial discharge is used for the insulating frame 6 including insulating body 10. A gap-free, high-strength connection is produced by insulating material introduced by vacuum casting or pressure injection and also a fine intermeshing of the frame 9.

A plurality of pressure fittings 11 constitute further important components that are embedded in the insulating frame 6 or insulating body 10. These integrated pressure fittings 11 are preferably situated exactly at the location of the fixing holes 4 of the semiconductor module 1, so that, with the aid of centring elements of the pressure fittings 11, the insulating frame 6 "latches" in the fixing holes 4 of the semiconductor module 1. As a result of this, a centred installation position of the semiconductor assembly 30 in the insulating frame 6 is ensured in a simple manner during mounting. The pressure fittings may additionally have stacked tensioning discs.

The pressure fittings 11, which, in the mounted state, press with predetermined pressure fine-elastically against the base/intermediate plate 3 of the semiconductor module 1, generate the required pressure per unit area for optimal heat dissipation. Possible imprecisions of the surface of the cooler 5 are automatically compensated for by the pressure fittings 11 so that a uniform semiconductor module contact pressure is effected over the entire press-on area. Fine gaps between cooler surface and ceramic plate 8 are bridged with a permanent insulating thermally conductive paste (for example thermally conductive paste made of silicone without conductive substances) that does not flow away, with the result that, on the one hand, the uniform heat dissipation to the cooler 5 is ensured and, on the other hand, no contamination inclusions are produced which might lead to partial discharges during later operation (long-term behaviour).

The force transmission path from the insulating frame 6 to the base/intermediate plate 3 of the semiconductor module 1 can readily be discerned in the sectional illustration in accordance with Fig. 1. At the location of the holes 12, the frame 9 reaches in a sleeve-type manner around the fixing screws 13, i.e. force is introduced directly into the stable and "settling-secure" insulating frame 6. Moreover, the insulating frame 6 projects over the pressure fittings 11 in the region of the corners, partial sections of the homogeneous insulating body 10 being situated between the frame 6 and the pressure fittings 11. These pressurized partial sections - referred to as pressure zones 17 hereinafter - are necessary for electrical insulation purposes.

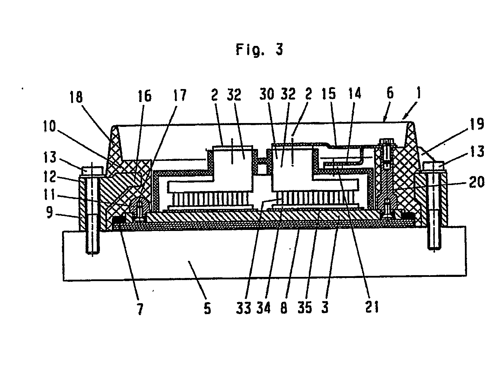

As revealed by Fig. 3, the semiconductor assemblies 30 have busbars ("small busbars") 32 for bonding wires 33, which connect to the actual chip groups 34, for example IGBT groups. The latter are fixed in a conventional manner by means of a ceramic layer 35 on the base/intermediate plate 3. The latter comprises e.g. copper or AlSiC. The ceramic plate 8 is formed from aluminium nitride or aluminium oxide, for example.

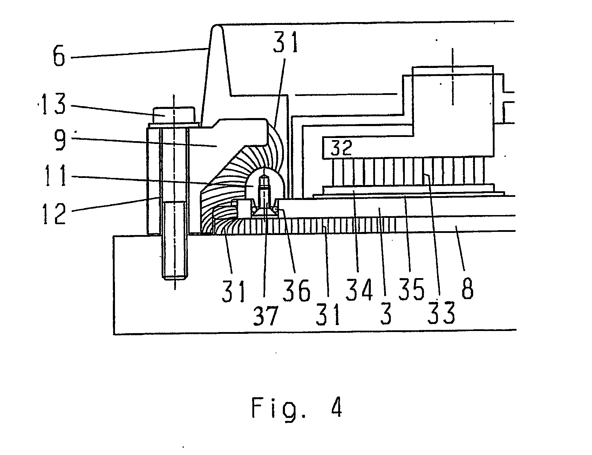

Fig. 4 represents a precise illustration of the pressure fitting 11. The latter has a screw 37 in the exemplary embodiment depicted, which screw is screwed into the insulating frame 6 with the interposition of an O-ring 36, whereby the preassembly mounting is furnished by means of the pressure fitting 11.

For the mounting of the insulating frame 6 on the cooler 5, holes 12 are provided in the insulating frame 6 preferably in direct proximity to the pressure fittings 11, through which holes fixing screws 13 reach and can be screwed into corresponding threaded holes in the cooler 5. The heads of the fixing screws 13 are arranged "behind" the insulating frame 6. This results (in conjunction with further measures) in a sufficient flashover distance between cooler 5 and to the busbar arrangement or the connections of the semiconductor assembly 30. As an alternative, it is also possible, of course, to provide the cooler 5 with corresponding stud bolts which engage into the holes or cutouts 12. The heads of the fixing screws 13 can also be counter-sunk in the frame 9 in order to increase the flashover distance.

The pressure force introduced via the fixing screws 13 is transmitted via overhanging arms 16 (also see Fig. 3) of the frame, the said partial sections of the insulating body 10 and the pressure fittings 11 to the base/intermediate plate 3. A gap remains between the insulating frame 6 and the cooler 5 in order that the forces of the fixing screws 13 take effect undivided.

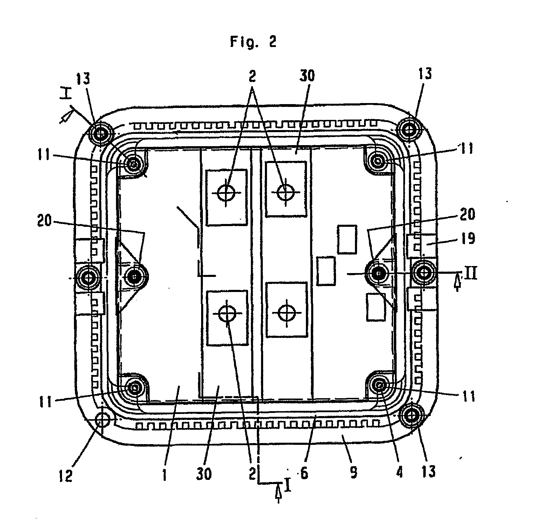

Fig. 2 illustrates a plan view of the semiconductor module 1. The electrical connections 2 of the semiconductor assembly 30 and the fixing holes 4 covered by the insulating frame 6 and also the insulating body 10 of the insulating frame 6 with holes 12 can be discerned. The formation of the frame 9 and also the ceramic plate 8 are sketched. It can readily be discerned that the insulating frame 6 closely encloses the semiconductor module 1, the pressure fittings 11 being situated in the region of the projections of the insulating body (see overhanging arms 16 in Fig. 3).

The mounting of a semiconductor module 1 on the cooler 5 is configured extremely simply. For premounting of the semiconductor module, the semiconductor assembly 30 (or the assemblies) is placed into the insulating frame 6. For locking purposes, the screws 37 are screwed in with O-rings 36 or other positively locking seals of the pressure fittings 11 (see Fig. 4). The electrical seal 7 is inserted and the ceramic plate 8 is emplaced. Both parts are coated beforehand, thereby providing a sufficient adhesion force during the further handling (in particular rotation) of the premounted semiconductor module before the actual mounting on the cooler 5. The fixing screws 13 are screwed into the threaded holes of the cooler 5 with a predetermined torque. When the insulating frame 6 is pressed on against the semiconductor module 1 or against the cooler 5, the elastic electrical seal 7 is compressed, which, in conjunction with the ceramic plate 8, reliably prevents a charge carrier transport between semiconductor module 1 and cooler 5 and produces a high-value contact resistance with respect to the cooler 5. Excess insulating thermally conductive paste is pressed over the edge of the ceramic plate 8 or forced into depositing grooves that are present.

As an alternative to the above-explained two-part construction of the insulating frame 6 from frame 9 and insulating body 10, the insulating frame 6 can, in accordance with a further embodiment, also be formed in one part from a carbon-fibre- or glass-fibre-reinforced. plastic.

Fig. 3 shows a detail illustration of a semiconductor module in section. The semiconductor module 1, mounted on the cooler 5, with electrical connections 2 (main connections) and also control connections 21 and with base/intermediate plate 3 can be discerned. The semiconductor module 1 is mounted on the cooler 5 by means of the insulating frame 6 formed in two parts from frame 9 and insulating body 10, the ceramic plate 8 which can effect translatory movement being clamped in between base/intermediate plate 3 and cooler 5. In particular, overhanging arms 16 of the frame 9, which is fixed on the cooler 5 by means of fixing screws 13, press against the pressure fittings 11 via pressure zones 17 in the insulating body 10. A toothed ribbing is expediently provided between frame 9 and insulating body 10, which ensures the required mechanically high-strength and stable metal/plastic connection. Reinforcing ribs 19 of the insulating frame 6 or insulating body 10 also serve for attaining mechanical stability.

In order to enable operation in particular at higher voltages and/or powers, provision is made of "fictitious" potential connections 14 and/or 15 (contained in the power converter assembly in the busbar arrangement) between control connection 21 (gate) and base/intermediate plate 3 and/or between electrical connection 2 (main connection, emitter) and base/intermediate plate 3. These electrical connections to the base/intermediate plate 3 are advantageously effected, for example, via pressure/bushing connections 20 in the insulating frame or insulating body 10, which have a direct electrical connection to the pressure fittings 11 and make contact with the fictitious potential connections 14 and/or 15 via screw connections accessible from the top side of the semiconductor module 1. The pressure/bushing fittings 20 have a dual function in this case. On the one hand, they provide the electrical connection that is PD-free as described, and on the other hand they provide the mechanical contact pressure in the centre of the semiconductor module.

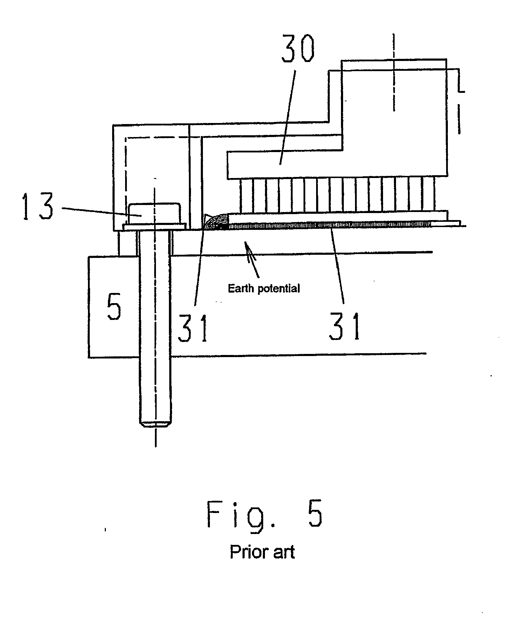

These proposed electrical connections (potential connections) between base/intermediate plate 3 and emitter potential and/or gate potential have the advantage that the critical voltage load (or the electrical field strength), in particular in the edge region in the case of the known prior art, between the transistors/diode chips or the ceramic insulation (DCB) thereof - see ceramic layer 35 - and the metallic and electrically conductive base/intermediate plate is reduced to a few volts. Furthermore, undefined intermediate potentials cannot form. The critical loading zones for the electrical field strength (see field lines 31 in Fig. 5) are moved to the highly insulating ceramic plate 8, the insulating body 10 with peripheral insulating collar 18 and the electrical seal 7. The loads with regard to the electric field strength can be managed there in a simple and effective manner by means of the measures explained above. The insulating collar 18 is dimensioned with regard to the required creepage paths and the flashover distance.

Fig. 4 shows the left-hand partial detail of the subject-matter of Fig. 3 in an enlarged illustration, in order to illustrate the profile of the field lines and of the field strength primarily in the critical outer region of the base/intermediate plate 3 and the semiconductor assembly 30. The field lines are designated by 31. It is noticeable that, in contrast to the profile of the field lines in the case of the prior art in accordance with Fig. 5, the field lines 31 run distributed in extensive fashion, so that a comparatively low field strength is present. This brings about, in principle, a high security in the case of semiconductor modules operated with high voltages and is advantageous in comparison with the prior art in accordance with Fig. 5, in which comparable components are designated by the same reference numerals as in Figs. 1 to 4. In the region of the margin or edge of the base/intermediate plate 3 and also towards the cooler 5, the field lines 31 that lie close together indicate high field strength there.

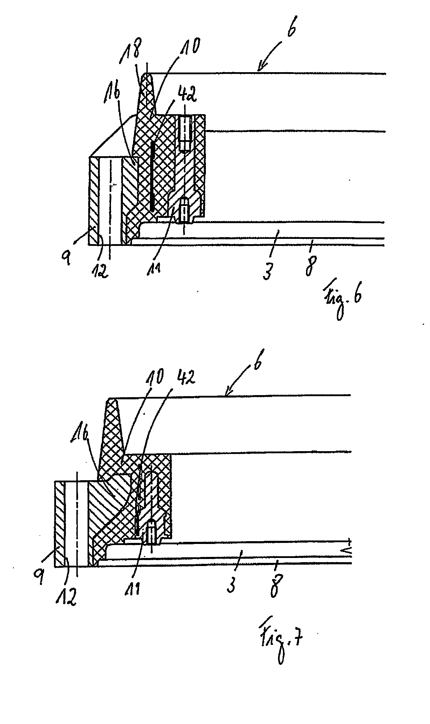

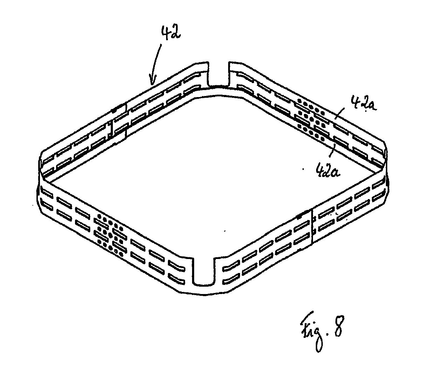

Figs. 6 and 7 show a partial view of an alternative embodiment of the semiconductor module, which differs from the module described with reference to Figs. 1 to 3 by virtue of an additional screen and also altered dimensioning of the insulating frame and of the pressure fittings. The mutually corresponding parts are again designated by the same reference numerals. In this exemplary embodiment, an additional screen 42 is cast into the insulating body 10 of the insulating frame 6. The screen 42, which prevents partial discharges in the gap between insulating body 10 and semiconductor module, is an essentially rectangular metal ring which is bent over at its longitudinal edges 42a in order to avoid sharp edges and is multiply perforated for the penetration of the casting resin (Fig. 8). The metal ring 42 is electrically connected to the pressure fittings 11. It causes the voltage present at the base/intermediate plate 3 to move upstream into the insulating frame 6, as a result of which the discharges are prevented. To ensure that the metal ring has space in the insulating body 10, the overhanging arm 16 of the frame 6 has a smaller spatial extent than in the exemplary embodiment in accordance with Figs. 1 to 3.

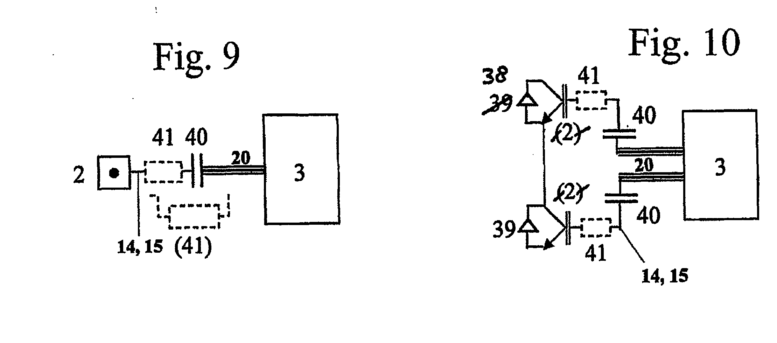

Figs. 9 and 10 diagrammatically illustrate the possibilities - already mentioned in part above - for the defined potential division between chips and base/intermediate plate. Fig. 9 shows a defined capacitance 40 between the electrical connections 2 with potential connections 14 or 15 and the pressure/bushing fitting 20 to the base/intermediate plate 3. If appropriate, a defined resistance 41 is connected in series with the capacitance 40. If appropriate, a high-value resistance 41 is used for the resistance 41 or the capacitance/resistance series circuit 40/41.

The arrangement in accordance with Fig. 9 shows an optimized utilization of the earth insulation, DCB insulation and ceramic insulation of the base/intermediate plate 3 at very high voltages. A C-controlled or R-controlled or C/R-controlled, i.e. partial utilization of the series-connected DCB insulation and ceramic earth insulation is effected (C = capacitance, R = resistance). In this respect, for the purpose of controlling a defined divider voltage between emitter - base/intermediate plate - cooler, the capacitance 40 and/or the resistance 41 is interposed into the potential connection 14 or 15. The capacitance 40 and/or the resistance 41 thus bring about a defined potential division between the IGBT chips and the cooler 5. Capacitance 40 and/or resistance 41 are dimensioned such that the DCB earth insulation of the chips of the IGBT module are little or only partly exhausted by the potential division effected.

Fig. 10 shows an arrangement with two IGBT individual switches 38, 39, whose electrical connections 2 are connected to the base/intermediate plate 3 via separate capacitances 40 and separate pressure/bushing fittings 20. If appropriate, resistances 41 are connected in series with the capacitances 40. If appropriate, high-value resistances 41 are used for the resistances 41 or the capacitance/resistance series circuits 40/41.

The arrangement in accordance with Fig. 10 produces a virtually "imparted" emitter or gate voltage, i.e. a virtually "imparted" emitter or gate voltage is established at the base/intermediate plate 3. In an advantageous manner, as a result of this, the above-discussed load-relieving of the DCB chip insulation (ceramic layer 35) by means of the arrangement of insulating frame 6/electrical seal 7/ceramic plate 8/insulating body 10 is obtained even in the case of a series circuit or cascade circuit of two or more IGBT individual switches in a semiconductor module. The potential of the base/intermediate plate 3 is "imparted" in such a way that, on the one hand, orientation to the highest emitter voltage of the respective IGBT individual switch is effected and, on the other hand, it is possible to "shave", i.e. control, the voltage matching via capacitance and/or resistance. Staggered, different emitter potentials are automatically established and are transmitted to the base/intermediate plate 3.

### List of reference symbols

- 1: Semiconductor module
- 2: Electrical connections
- 3: Base/intermediate plate
- 4: Fixing holes
- 5: Cooler
- 6: Insulating frame
- 7: Electrical seal
- 8: Ceramic plate
- 9: Frame
- 10: Insulating body
- 11: Pressure fitting
- 12: Holes
- 13: Fixing Screw
- 14: Potential connection
- 15: Potential connection
- 16: Overhanging arm of the frame
- 17: Pressure zone in the insulating body
- 18: Insulating collar
- 19: Reinforcing ribs
- 20: Pressure/bushing connection to the base/intermediate plate
- 21: Control connection
- 30: Semiconductor assembly
- 31: Field lines
- 32: Busbars
- 33: Bonding wires
- 34: Chip groups
- 35: Ceramic layer
- 36: O-ring
- 37: Screw
- 38: IGBT individual switch
- 39: IGBT individual switch
- 40: Capacitance
- 41: Resistance
- 42: Screen

## Claims

1. Semiconductor module whose semiconductor chips are arranged on a base/intermediate plate (3), having
- an insulating frame (6),
- a ceramic plate (8), which is arranged between the base/intermediate plate and a cooler (5) provided for the mounting of the semiconductor module,
- the insulating frame (6) enclosing the semi-conductor module and being designed for the fixing thereof on the cooler (5) and also having the structural height of the semiconductor module,
- an electrical connection (2) and a control connection (21) ,
- a potential connection (14) between the electric connection (2) and the base/intermediate plate (3) and/or a potential connection (15) between the control connection (21) and the base/intermediate plate (3). **characterized in that** the contour of the insulating frame (6) closely encloses the semiconductor module (1) and the said insulating frame projects via fixing holes (4) in the base/intermediate plate (3), pressure fittings (11) that press against the base/intermediate plate (3) being integrated in the insulating frame (6) and the insulating frame (6) having holes (12) for screwing on the cooler (5).

2. Semiconductor module according to claim 1, **characterized in that** the dimensions of the ceramic plate (8) are slightly larger than the dimensions of the base/intermediate plate (3), with the result that a peripheral free edge area suitable for receiving an elastic electrical seal (7) is produced on the ceramic plate (8).

3. Semiconductor module according to Claim 2, **characterized in that** a ring made of soft rubber or plastic without conductive dopings is used as the electrical seal (7).

4. Semiconductor module according to one of the preceding claims, wherein the insulating frame (6) is constructed from two main components, an inner frame (9) and an insulating body (10),
**characterized by** overhanging arms (16) of the inner frame (9), whereby pressure zones (17) are formed in the insulating body (10) with respect to the pressure fittings (11).

5. Semiconductor module according to one of the preceding claims,
**characterized in that** the pressure fittings (11) have screws (37) which, sealed by positively locking seals (36), reach through the fixing holes (4) in the base/intermediate plate (3).

6. Semiconductor module according to one of the preceding claims,
**characterized in that** the pressure fittings (11) have tensioning discs.

7. Semiconductor module according to one of the preceding claims,
**characterized in that** the insulating frame (6) or insulating body (10) is provided with an insulating collar (18).

8. Semiconductor module according to one of the preceding claims, **characterized in that**, in the insulating frame (6) or insulating body (10), provision is made of at least one pressure/bushing connection (20) for producing the potential connection or potential connections (14, 15).

9. Semiconductor module according to one of the preceding claims,
**characterized by** a capacitance (40) or a resistance (41) or a series circuit comprising capacitance (40) and resistance (41) between electrical or control connection (2, 21) and pressure/bushing connection (20).

10. Semiconductor module according to claim 9, **characterized in that** a screen (42) is integrated into the insulating frame (10).

## Patentansprüche

1. Halbleitermodul, dessen Halbleiterchips auf einer Basis-/Zwischenplatte (3) angeordnet sind, umfassend:
- einen Isolierrahmen (6),
- eine Keramikplatte (8), die zwischen der Basis-/Zwischenplatte und einem für die Montage des Halbleitermoduls bereitgestellten Kühler (5) angeordnet ist,
- wobei der Isolierrahmen (6) das Halbleitermodul umschließt und für die Befestigung davon an den Kühler (5) entworfen ist und auch die strukturelle Höhe des Halbleitermoduls aufweist,
- eine elektrische Verbindung (2) und eine Steuerverbindung (21),
- eine potenzielle Verbindung (14) zwischen der elektrischen Verbindung (2) und der Basis-/Zwischenplatte (3) und/oder eine potenzielle Verbindung (15) zwischen der Steuerverbindung (21) und der Basis-/Zwischenplatte (3), **dadurch gekennzeichnet, dass** der Umriss des Isolierrahmens (6) das Halbleitermodul (1) eng umschließt und der Isolierrahmen über Befestigungslöcher (4) in der Basis-/Zwischenplatte (3) hervorsteht, wobei Druckbefestigungen (11), die gegen die Basis-/Zwischenplatte (3) drücken, in den Isolierrahmen (6) integriert sind und der Isolierrahmen (6) Löcher (12) aufweist, um auf den Kühler (5) geschraubt zu werden.

2. Halbleitermodul nach Anspruch 1, **dadurch gekennzeichnet, dass** die Abmessungen der Keramikplatte (8) geringfügig größer als die Abmessungen der Basis-/Zwischenplatte (3) sind, mit dem Ergebnis, dass ein peripherer freier Kantenbereich, der geeignet ist, um eine elastische elektrische Dichtung (7) aufzunehmen, auf der keramischen Platte (8) gebildet wird.

3. Halbleitermodul nach Anspruch 2, **dadurch gekennzeichnet, dass** ein Ring, hergestellt aus einem weichen Gummi oder Plastik ohne leitfähige Dotierungen als elektrische Dichtung (7) verwendet wird.

4. Halbleitermodul nach einem der vorhergehenden Ansprüche, wobei der Isolierrahmen (6) aus zwei Hauptkomponenten, ein innerer Rahmen (9) und ein Isolierkörper (10) konstruiert ist, **gekennzeichnet durch** überhängende Arme (16) des inneren Rahmens (9), wobei Druckzonen (17) im Isolierkörper (10) mit Bezug auf die Druckbefestigungen (11) gebildet sind.

5. Halbleitermodul nach einem der vorhergehenden Ansprüche, **dadurch gekennzeichnet, dass** die Druckbefestigungen (11) Schrauben (37) aufweisen, die, durch formschlüssige Dichtungen (36) abgedichtet, durch die Befestigungslöcher (4) in der Basis-/Zwischenplatte (3) reichen.

6. Halbleitermodul nach einem der vorhergehenden Ansprüche, **dadurch gekennzeichnet, dass** die Druckbefestigungen (11) Spannungsscheiben aufweisen.

7. Halbleitermodul nach einem der vorhergehenden Ansprüche, **dadurch gekennzeichnet, dass** der Isolierrahmen (6) oder der Isolierkörper (10) mit einem Isolierkragen (18) ausgestattet ist.

8. Halbleitermodul nach einem der vorhergehenden Ansprüche, **dadurch gekennzeichnet, dass** im Isolierrahmen (6) oder im Isolierkörper (10) mindestens eine Druck-/Durchführungsverbindung (20) bereitgestellt ist, um die potenzielle Verbindung oder die potenziellen Verbindungen (14, 15) herzustellen.

9. Halbleitermodul nach einem der vorhergehenden Ansprüche, **gekennzeichnet durch** eine Kapazität (40) oder einen Widerstand (41) oder eine Reihenschaltung umfassend eine Kapazität (40) und einen Widerstand (41) zwischen einer elektrischen oder Steuerverbindung (2, 21) und einer Druck-/Durchführungsverbindung (20).

10. Halbleitermodul nach Anspruch 9, **dadurch gekennzeichnet, dass** ein Bildschirm (42) in den Isolierrahmen (10) integriert ist.

## Revendications

1. Module à semi-conducteurs dont les puces semi-conductrices sont agencées sur une plaque de base/intermédiaire (3), comportant :
- un cadre isolant (6),
- une plaque en céramique (8), qui est agencée entre la plaque de base/intermédiaire et un dispositif de refroidissement (5) prévu pour le montage du module à semi-conducteurs,
- le cadre isolant (6) enfermant le module à semi-conducteurs et étant conçu pour sa fixation sur le dispositif de refroidissement (5) et ayant également la hauteur structurelle du module à semi-conducteurs,
- une connexion électrique (2) et une connexion de commande (21),
- une connexion de potentiel (14) entre la connexion électrique (2) et la plaque de base/intermédiaire (3) et/ou une connexion de potentiel (15) entre la connexion de commande (21) et la plaque de base/intermédiaire (3),
**caractérisé en ce que** le contour du cadre isolant (6) enferme étroitement le module à semi-conducteurs (1) et ledit cadre isolant s'étend à travers des trous de fixation (4) dans la plaque de base/intermédiaire (3), des éléments de pression (11) qui pressent contre la plaque de base/intermédiaire (3) étant intégrés dans le cadre isolant (6) et le cadre isolant (6) comportant des trous (12) pour le vissage sur le dispositif de refroidissement (5).

2. Module à semi-conducteurs selon la revendication 1,
**caractérisé en ce que** les dimensions de la plaque en céramique (8) sont légèrement plus grandes que les dimensions de la plaque de base/intermédiaire (3), avec pour résultat qu'une zone de bord libre périphérique appropriée pour recevoir un joint électrique élastique (7) est produite sur la plaque en céramique (8).

3. Module à semi-conducteurs selon la revendication 2,
**caractérisé en ce qu'**une bague réalisée en caoutchouc mou ou en matière plastique sans dopages conducteurs est utilisée en tant que joint électrique (7).

4. Module à semi-conducteurs selon l'une des revendications précédentes, dans lequel le cadre isolant (6) est réalisé à partir de deux composants principaux, un cadre intérieur (9) et un corps isolant (10),
**caractérisé par** des bras en surplomb (16) du cadre intérieur (9), moyennant quoi des zones de pression (17) sont formées dans le corps isolant (10) en relation avec les éléments de pression (11).

5. Module à semi-conducteurs selon l'une des revendications précédentes, **caractérisé en ce que** les éléments de pression (11) comportent des vis (37) qui, scellées par des joints de verrouillage positif (36), atteignent à travers les trous de fixation (4) la plaque de base/intermédiaire (3).

6. Module à semi-conducteurs selon l'une des revendications précédentes, **caractérisé en ce que** les éléments de pression (11) comportent des disques de tension.

7. Module à semi-conducteurs selon l'une des revendications précédentes, **caractérisé en ce que** le cadre isolant (6) ou le corps isolant (10) est pourvu d'une collerette isolante (18).

8. Module à semi-conducteurs selon l'une des revendications précédentes, **caractérisé en ce que**, dans le cadre isolant (6) ou le corps isolant (10), il est prévu au moins une connexion par pression/par douille (20) pour produire la connexion de potentiel ou les connexions de potentiel (14, 15).

9. Module à semi-conducteurs selon l'une des revendications précédentes, **caractérisé par** une capacitance (40) ou une résistance (41) ou un circuit série comprenant une capacitance (40) et une résistance (41) entre la connexion électrique ou de commande (2, 21) et la connexion par pression/par douille (20).

10. Module à semi-conducteurs selon la revendication 9,
**caractérisé en ce qu'**un blindage (42) est intégré dans le cadre isolant (10).
